# EUROPÄISCHE PATENTSCHRIFT

(11) **EP 1 060 519 B1**
(45) Veröffentlichungstag und Bekanntmachung des Hinweises auf die Patenterteilung: **25.04.2007**
(21) Anmeldenummer: 98966780.3
(22) Anmeldetag: 17.12.1998
(51) Int. Cl.: H01L 29/788, H01L 21/28, H01L 27/115, H01L 21/8247

(54) **VERFAHREN ZUR HERSTELLUNG EINER SPEICHERZELLE MIT MOS-TRANSISTOR**
METHOD FOR PRODUCING A MOS TRANSISTOR MEMORY CELL
PROCEDE DE PRODUCTION D'UNE CELLULE DE MEMOIRE A TRANSISTOR MOS

(30) Priorität: 20.02.1998 DE 19807188
(43) Veröffentlichungstag der Anmeldung: 20.12.2000
(73) Patentinhaber: Qimonda AG, 81739 München (DE)
(72) Erfinder: HOFMANN, Franz, D-80995 München (DE); WILLER, Josef, D-85521 Riemerling (DE)
(74) Vertreter: Müller - Hoffmann & Partner
(86) Internationale Anmeldenummer: PCT/DE1998/003716
(87) Internationale Veröffentlichungsnummer: WO 1999/043030

(56) Entgegenhaltungen:
- EP-A- 0 718 895
- US-A- 5 049 515
- US-A- 5 495 441
- PATENT ABSTRACTS OF JAPAN vol. 095, no. 011, 26. Dezember 1995 -& JP 07 221206 A (SANYO ELECTRIC CO LTD), 18. August 1995
- PATENT ABSTRACTS OF JAPAN vol. 097, no. 004, 30. April 1997 -& JP 08 321563 A (SANYO ELECTRIC CO LTD), 3. Dezember 1996

## Beschreibung

Die Erfindung betrifft ein Verfahren zur Herstellung einer Speicherzelle mit wenigstens einem MOS-Transistor,
- wobei der Transistor eine Source, eine erste Gateelektrode, eine zweite Gateelektrode, eine Drain und einen Kanal enthält,
- wobei die erste Gateelektrode isoliert ist und eine elektrische Ladung enthalten kann,
- wobei an die zweite Gateelektrode eine Steuerspannung gelegt werden kann,
- wobei die Source, die Drain und der Kanal durch verschieden dotierte Bereiche eines Halbleitersubstrats gebildet werden und
- wobei sich zwischen dem Halbleitersubstrat und den Gateelektroden wenigstens eine dielektrische Schicht, die ein Gatedielektrikum bildet, befindet.

Eine derartige Speicherzelle ist in der US-A 5 242 848 beschrieben. Hierbei erstreckt sich die erste Gateelektrode flach auf einer dielektrischen Schicht und weist eine Spitze auf. Die zweite Gateelektrode weist mehrere Bereiche auf, wobei ein unterer Bereich auf der gleichen dielektrischen Schicht wie die erste Gateelektrode angeordnet ist und wobei ein oberer Bereich der zweiten Gateelektrode bereichsweise oberhalb der ersten Gateelektrode angeordnet ist. Durch diese Anordnung wird lokal ein besonders großer elektrischer Feldgradient an der Oberfläche der ersten Gateelektrode geschaffen. Ein Spitzeneffekt begünstigt ein Fowler-Nordheim-Tunneln. Bei dem Fowler-Nordheim-Tunneln handelt es sich um einen Ladungstransport durch einen Isolator. Der Ladungstransport durch einen Isolator ist generell stark abhängig von dem angelegten elektrischen Feld. Bei dem Fowler-Nordheim-Tunneln weist die elektrische Stromdichte j die besondere Abhängigkeit j = C₁ x ε² exp (-ε₀/ε) auf, wobei ε die elektrische Feldstärke und C₁ und ε₀ von der effektiven Masse der Ladungsträger und der Höhe der Barriereschicht abhängige Konstanten sind. Durch die hohe elektrische Felddichte kann diese gattungsgemäße Speicherzelle besonders einfach elektrisch gelöscht werden.

US-A-5 495 441 offenbart eine Speicherzelle mit einem Graben. JP-07 221206 A offenbart eine erste Gateelektrode mit einer scharfen Kante.

Es hat sich jedoch gezeigt, daß diese Speicherzelle bei Strukturgrößen von 0,25 µm und darunter nicht die für Speicherzellen erforderliche Zuverlässigkeit aufweist.

Der Erfindung liegt die Aufgabe zugrunde, ein Herstellungsverfahren für eine gattungsgemäße Speicherzelle zu schaffen, welche die Nachteile des Standes der Technik überwindet. Insbesondere soll diese Speicherzelle mit Strukturgrößen von 0,25 µm und darunter realisierbar sein. Ferner soll eine derartige Speicherzelle möglichst einfach herstellbar sein.

Diese Aufgabe wird durch ein Verfahren zur Herstellung einer Speicherzelle gemäß Anspruch 1 gelöst. Weitere Ausgestaltungen der Erfindung gehen aus den übrigen Ansprüchen hervor.

Die gattungsgemäße Speicherzelle wird so ausgestattet, daß die zweite Gateelektrode wenigstens in einem Bereich in das Halbleitersubstrat eindringt. Die erste Gateelektrode weist wenigstens eine Spitze auf, die der zweiten Gateelektrode zugewandt ist.

Dabei ist die zweite Gateelektrode mindestens teilweise in einem Graben angeordnet, entlang dessen Seitenwand sich ein leitender Kanal ausbilden kann. Die Spitze der ersten Gateelektrode ist an der Grabenkante angeordnet.

Die Herstellung sieht vor, einen MOS-Transistor einer Speicherzelle so auszugestalten, daß er zwei räumlich voneinander getrennte Gateelektroden aufweist, wobei die erste Gateelektrode eine einprogrammierte elektrische Ladung enthält, und wobei die zweite Gateelektrode mit einer Leitung verbunden ist. Die zweite Gateelektrode ist hierbei so ausgestaltet, daß sie als ganzes oder in einem Teilbereich in das Halbleitersubstrat eindringen kann.

Dabei ist die erste Gateelektrode als floatende Gateelektrode ausgebildet. Der Begriff floatende Gateelektrode weist darauf hin, daß die erste Gateelektrode mit einer variablen elektrischen Ladung versehen werden kann. Die erste Gateelektrode befindet sich wenigstens bereichsweise zwischen der zweiten Gateelektrode und dem Kanal des MOS-Transistors. Durch diese Anordnung hängt die Einsatzspannung einer Speicherzelle mit MOS-Transistor und floatender Gateelektrode von der auf der floatenden Gateelektrode befindlichen Ladung ab.

Eine Ausführungsform der Speicherzelle zeichnet sich dadurch aus, daß die Source tiefer im Halbleitersubstrat angeordnet ist als die Drain, und daß die zweite Gateelektrode so in das Halbleitersubstrat eindringt, daß die zweite Gateelektrode sich mindestens abschnittsweise oberhalb der Source befindet.

Es ist besonders vorteilhaft, daß die zweite Gateelektrode in einem weiteren Bereich über das Halbleitersubstrat hinausragt.

Ein besonders kompaktes Zellenfeld läßt sich dadurch erreichen, daß die erste Gateelektrode wenigstens abschnittsweise parallel zu der zweiten Gateelektrode verläuft.

Hierdurch ist es möglich, daß eine einzelne Gateelektrode zwei vorzugsweise vertikale MOS-Transistoren ansteuert. Bei der Gateelektrode handelt es sich um die hier als zweite Gateelektrode bezeichnete Auswahl-Gateelektrode (Select-Gate).

Ein Spitzeneffekt läßt sich besonders günstig dadurch erreichen, daß der Bereich der zweiten Gateelektrode, der in das Halbleitersubstrat eindringt, durch einen vertikalen Vorsprung der zweiten Gateelektrode gebildet wird, und daß ein anderer Bereich der zweiten Gateelektrode sich im wesentlichen parallel zu einer Oberfläche des Halbleitersubstrats erstreckt.

Eine kompakte Bauweise, bei der die zweite Gateelektrode (Select-Gate) zwei erste (floatende) Gateelektroden ansteuert, kann in besonders einfacher und zweckmäßiger Weise dadurch erzielt werden, daß die erste Gateelektrode einen Abschnitt aufweist, der sich parallel zu dem vertikalen Teil der zweiten Gateelektrode erstreckt.

Eine Anordnung mit ausgeprägtem Spitzeneffekt und dementsprechend begünstigten Fowler-Nordheim-Tunneln läßt sich dadurch erzielen, daß die erste Gateelektrode sich im wesentlichen parallel zu einer Oberfläche des Halbleitersubstrats erstreckt, und daß die erste Gateelektrode in einem anderen, vertikal zu dem Halbleitersubstrat ausgerichteten, Bereich wenigstens eine Spitze aufweist.

Eine weitere Erhöhung des Spitzeneffekts läßt sich dadurch erzielen, daß die Spitze der ersten Gateelektrode in wenigstens eine Ausnehmung der zweiten Gateelektrode eindringt.

Die Erfindung betrifft ein Verfahren zur Herstellung einer Speicherzelle mit wenigstens einem MOS-Transistor, wobei auf einem Halbleitersubstrat eine dielektrische Schicht für die Bildung eines Gatedielektrikums, eine erste elektrisch leitfähige Schicht für die Bildung einer ersten Gateelektrode, eine weitere dielektrische Schicht und eine zweite elektrisch leitfähige Schicht für die Bildung einer zweiten Gateelektrode abgeschieden werden und wobei in dem Halbleitermaterial verschieden dotierte Gebiete für eine Source, eine Drain und einen Kanal gebildet werden. Dieses Verfahren zeichnet sich erfindungsgemäß dadurch aus, daß auf der ersten elektrisch leitfähigen Schicht eine Spitze erzeugt wird, und daß die zweite Gateelektrode so erzeugt wird, daß sie wenigstens in einem Bereich in das Halbleitersubstrat eindringt.

Dieses Verfahren wird so durchgeführt, daß auf das Halbleitersubstrat zuerst eine dielektrische Schicht und dann eine elektrisch leitende Schicht, die in der fertigen Speicherzelle als erste Gateelektrode dient, erzeugt wird, und daß in einem späteren Prozeßschritt ein Bereich aus der ersten elektrisch leitenden Schicht und aus dem darunter liegenden Bereich der dielektrischen Schicht sowie des Halbleitersubstrats entfernt werden.

Ein derartiges Entfernen kann beispielsweise durch einen oder mehrere Atzprozesse erfolgen. Die Ätzprozesse sind so gewählt, daß sie eine möglichst anisotrope Ätzung des Halbleitersubstrats ermöglichen.

Eine kompakte Zelle, bei der die zweite Gateelektrode (das Select-Gate) zwei verschiedene Transistoren steuert wird in einem selbstjustierten Prozeß erzeugt. Hierdurch werden genau definierte Geometrien der Gateelektroden und ihrer Umgebung erzielt. Ein derartiger selbstjustierter Prozeß erfolgt so, daß auf dem Halbleitersubstrat zuerst eine dielektrische Schicht und dann eine elektrisch leitende Schicht, die in der fertigen Speicherzelle als erste Gateelektrode dient, erzeugt wird, und daß in einem späteren Prozeßschritt ein Bereich aus der ersten elektrisch leitenden Schicht und aus dem darunter liegenden Bereich der dielektrischen Schicht sowie des Halbleitersubstrats entfernt werden.

Dieses Verfahren wird zweckmäßigerweise so durchgeführt, daß das bereichsweise Entfernen der ersten elektrisch leitfähigen Schicht, der ersten dielektrischen Schicht sowie des Halbleitersubstrats durch einen oder mehrere Ätzvorgänge erfolgt.

Weitere Vorteile, Besonderheiten und zweckmäßige Weiterbildungen der Erfindung ergeben sich aus den Unteransprüchen und der nachfolgenden Darstellung eines bevorzugten Ausführungsbeispiels der Erfindung anhand der Zeichnungen.

Von den Zeichnungen zeigt
- Figur 1: einen Querschnitt durch das Halbleitersubstrat nach Auftragung einer dielektrischen Schicht, einer ersten elektrisch leitfähigen Schicht und einer dielektrischen Schicht,
- Figur 2: einen Querschnitt durch das Halbleitersubstrat nach Ätzung und Füllung eines Grabens,
- Figur 3: einen Querschnitt durch das Halbleitersubstrat nach einem selektiven Wegätzen des Halbleitersubstrats und der dielektrischen Schicht sowie einem Auftragen einer weiteren Halbleiterschicht,
- Figur 4: einen Querschnitt durch das Halbleitersubstrat nach einer isotropen Oxidation der weiteren Halbleiterschicht,
- Figur 5: einen Querschnitt durch das Halbleitersubstrat nach einem Wegätzen der Halbleiterschicht,
- Figur 6: einen Querschnitt durch das Halbleitersubstrat nach Abscheiden einer Isolationsschicht und Entfernen des in dem Graben enthaltenen Füllmaterials,
- Figur 7: einen Querschnitt durch das Halbleitersubstrat nach einer Aufbringung eines elektrisch leitfähigen Materials, das in der fertiggestellten Speicherzelle eine zweite Gateelektrode bildet,
- Figur 8: einen Ausschnitt aus Figur 7 im Übergangsbereich zwischen der ersten Gateelektrode und der zweiten Gateelektrode,
- Figur 9: eine Aufsicht auf eine Speicherzellenanordnung, die mehrere Speicherzellen enthält und
- Figur 10: ein Schaltbild der Speicherzellenanordnung.

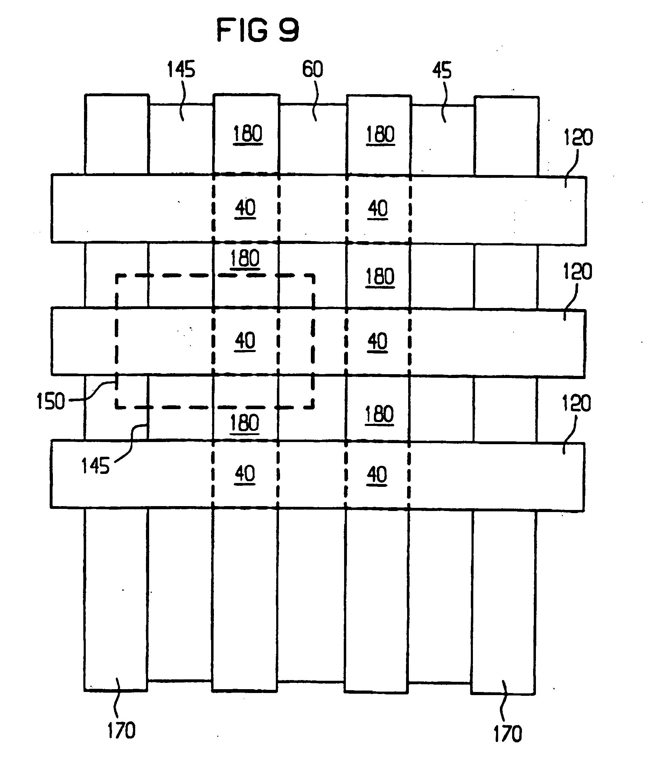

Eine besonders bevorzugte Ausführungsform der Erfindung beginnt mit einer Isolation von aktiven Gebieten. Diese Isolation kann durch die Erzeugung einer Isolationsstruktur beispielsweise mit einem LOCOS (Local Oxidation Of Silicon) oder einem STI (Shallow-Trench-Isolation) - Prozeß erfolgen. Die Isolationsstruktur beinhaltet Isolationsgräben 170 und Isolationsbereiche 180, deren Anordnung bei der fertig hergestellten Speicherzellenanordnung in Figur 9 dargestellt ist.

Anschließend werden in dem Halbleitersubstrat 10 Wannengebiete 20 und einen Kanal 25 bildende Gebiete vorzugsweise durch die Implantation von Ionen erzeugt. Beispielsweise werden im Fall eines NMOS-Transistors Bor-Ionen implantiert. Im Fall eines PMOS-Transistors erfolgt beispielsweise eine Implantation von Phosphor.

Anschließend wird eine dielektrische Schicht, die im fertigen Transistor ein Gatedielektrikum 30 bildet, aufgewachsen. Vorzugsweise wird die dielektrische Schicht oxidiert.

Danach wird als erste elektrisch leitfähige Schicht eine Halbleiterschicht, die in einem späteren Bearbeitungsschritt eine erste Gateelektrode 40 bildet, beispielsweise aus polykristallinem Silizium, abgeschieden. Die Halbleiterschicht wird mittels bekannter photolitographischer Prozeßschritte strukturiert. Im nächsten Prozeßschritt wird zur Bildung von Draingebieten ein Dotierstoff in einer leicht ansteigenden Konzentration implantiert (LDD-Implantation). Ein derart flaches Konzentrationsgefälle im Bereich der für die Bildung einer Drain 45 bestimmten Gebiete verlängert die Lebensdauer des Transistors. Nach der Strukturierung der Halbleiterschicht, die in einem späteren Bearbeitungsschritt die erste Gateelektrode 40 bildet, wird eine Isolationsschicht 50 abgeschieden. Die Isolationsschicht 50 weist dabei eine Dicke auf, die groß genug ist, um die Halbleiterschicht ganzflächig zu bedecken. Beispielsweise ist die Isolationsschicht 50 ungefähr 600 nm dick. Die Isolationsschicht 50 kann beispielsweise aus einem nach einem TEOS-(Tetra-Ethyl-Ortho-Silikat)-Verfahren abgeschiedenen Oxid bestehen. Hierzu wird Tetra-Ethyl-Ortho-Silikat: Si(OC₂H₅)₄ vorzugsweise bei einer Temperatur von etwa 700 °C und einem Druck von 40 Pa in SiO₂ umgewandelt.

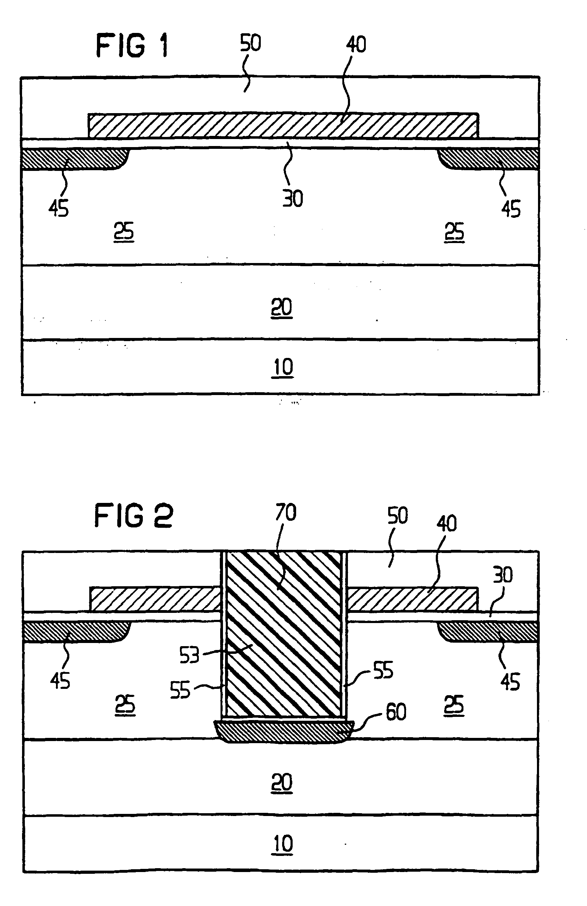

Anschließend wird die Isolationsschicht 50 durch ein geeignetes Planarisierungsverfahren, beispielsweise durch chemischmechanisches Polieren (CMP) planarisiert. Dieser Bearbeitungszustand ist in Figur 1 dargestellt.

Hierauf folgt mittels einer nicht dargestellten Maske eine Ätzung eines Grabens 53, der durch die Isolationsschicht 50, die erste Gateelektrode 40 und das Gatedielektrikum 30 in das Halbleitersubstrat eindringt. Dieses Eindringen erfolgt bis zu dem den Kanal 25 bildenden Gebiet.

Nach dem Ätzen des Grabens 53 erfolgt im Bereich des Bodens des Grabens eine Implantation eines Dotierstoffs, beispielsweise Arsen für die Bildung einer Source 60.

Im dargestellten Beispiel wird der MOS-Transistor so hergestellt, daß die Source 60 sich unterhalb einer zweiten Gateelektrode 120 befindet, während die Drains 45 sich im Bereich der Oberfläche des Halbleitersubstrats befinden. Die Drains 45 bilden in der fertigen Speicherzellenanordnung Bitleitungen.

Anschließend wird eine Oxidschutzschicht 55 so aufgebracht und strukturiert, daß sie den Boden und die Wände des Grabens 53 bedeckt. Die Oxidschutzschicht 55 wird vorzugsweise nach einem TEOS-(Tetra-Ethyl-Ortho-Silikat) Verfahren abgeschieden. Hierbei wird Tetra-Ethyl-Ortho-Silikat Si(OC₂H₅)₄ bei einer Temperatur von etwa 700 °C und einem bevorzugten Druck von 40 Pa in SiO₂ umgewandelt. Die Oxidschutzschicht 55 kapselt ein in einem nächsten Verfahrensschritt in den Graben 53 gefülltes Füllmaterial 70 ein.

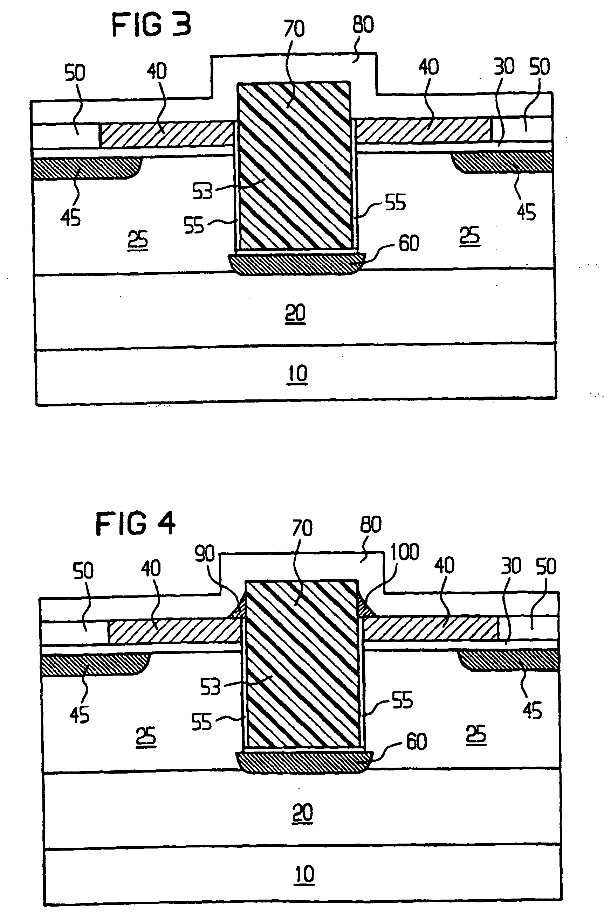

Anschließend wird der Graben 53 mit einem Füllmaterial 70, beispielsweise aus Siliziumnitrid Si₃N₄ gefüllt. Anschließend folgt ein Planarisierungsvorgang, beispielsweise durch einen CMP-Schritt, so daß das Füllmaterial 70 eine plane Oberfläche aufweist. Dieser Bearbeitungszustand ist in Figur 2 dargestellt.

Durch einen Ätzprozeß wird oberhalb der ersten Gateelektrode 40 die Isolationsschicht 50 entfernt. Bei diesem Ätzprozeß handelt es sich vorzugsweise um eine anisotrope Trockenätzung, die mit einem geeigneten Ätzgas, beispielsweise CF₄ oder CHF₃ und gegebenenfalls einem geeigneten Zusatz wie O₂ erfolgen kann.

Anschließend wird eine weitere Halbleiterschicht 80, beispielsweise aus polykristallinem Silizium konform abgeschieden. Dieser Bearbeitungszustand ist in Figur 3 dargestellt.

Die erste Gateelektrode 40 und die weitere Halbleiterschicht 80 sind rechtwinklig ausgebildet. Sie erstrecken sich senkrecht zu der dargestellten Zeichnungsebene.

Anschließend wird die weitere Halbleiterschicht 80, die zunächst durchgehend gestaltet ist, aufgetrennt, was mittels bekannter photolitographischer Prozeßschritte erfolgen kann. Diese Auftrennung der weiteren Halbleiterschicht 80 erfolgt um eine Isolierung der ersten Gateelektrode 40 sicherzustellen.

Das Auftrennen der weiteren Halbleiterschicht 80 erfolgt in einer zu der dargestellten Querschnittsfläche parallelen, nicht dargestellten Ebene.

Anschließend erfolgt eine isotrope Oxidation der weiteren Halbleiterschicht 80. Diese Oxidation erfolgt so weit, daß nur im Grenzbereich zu dem Graben 53 Spitzen 90 und 100 der weiteren Halbleiterschicht 80 nicht in ein Oxid umgewandelt werden.

Die Spitzen 90, 100 weisen die Form von Schneidkanten auf, deren Längsrichtung sich senkrecht zu der Darstellungsebene erstreckt. Dieser Bearbeitungszustand ist in Figur 4 dargestellt.

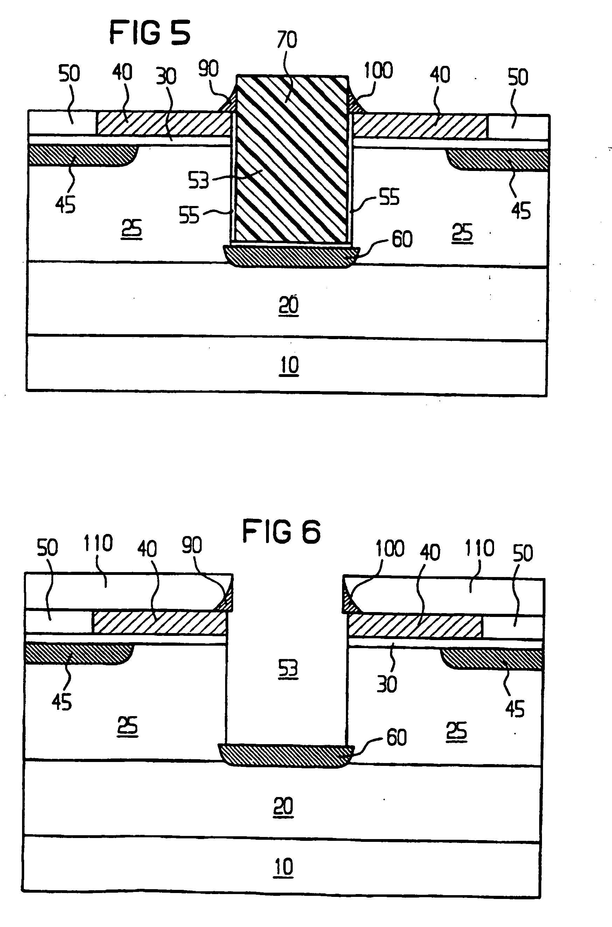

Zuvor wurde das Verfahren für den besonders bevorzugten Fall beschrieben, daß die Spitzen 90 und 100 als nicht oxidierte Reste der zweiten Halbleiterschicht 80 bestehen bleiben. Die Erzeugung der Spitzen 90 und 100 kann jedoch auch auf eine andere Weise erfolgen. So ist es beispielsweise auch möglich, das Verfahren mit einem Herausätzen der Spitzen 90 und 100 durchzuführen. In diesem Fall ist lediglich ein weiterer Prozeßschritt erforderlich, durch den oberhalb der ersten Gateelektrode eine zusätzliche Isolationsschicht gebildet wird. So werden die Spitzen 90 und 100 alternativ dadurch gebildet, daß die Halbleiterschicht 80 so geätzt wird, daß die Spitzen 90 und 100 stehen bleiben. Hierzu wird zweckmäßigerweise ein isotroper Ätzprozeß durchgeführt, der sowohl als ein naßchemischer Ätzprozeß als auch als ein Trockenätzprozeß erfolgen kann. Das Ergebnis eines derartigen Ätzprozesses ist in Figur 5 dargestellt.

Anschließend wird eine weitere Isolationsschicht 110 aufgetragen. Hierzu kann beispielsweise Tetra-Ethyl-Ortho-Silikat (TEOS;Si(OC₂H₅)₄) bei einer Temperatur im Bereich von 700 °C und einem Druck im Bereich von 10 Pa bis 100 Pa, bevorzugt 40 Pa, in SiO₂ umgewandelt werden. Die Dicke der weiteren Isolationsschicht 110 ist mindestens so groß wie die Höhe der Spitzen 90, 100. Wurden die Spitzen 90, 100 als nicht oxidierte Reste der zweiten Halbleiterschicht 80 erzeugt, so kann die oxidierte zweite Halbleiterschicht 80 anstelle oder zusätzlich zu der weiteren Isolationsschicht 110 verwendet werden. Danach erfolgt ein Prozeß des chemisch-mechanischen Polierens (CMP), wobei das Füllmaterial 70, das heißt hier die Nitridfüllung, des Grabens 53 als Stoppschicht dient. Anschließend wird das Füllmaterial 70 naßchemisch entfernt. Hierbei wird auch die Oxidschutzschicht 55 entfernt. Dieser Bearbeitungszustand ist in Figur 6 dargestellt.

Anschließend erfolgt in dem Graben 53 eine thermische Oxidation, so daß sich ein Gatedielektrikum 115 bildet. Die thermische Oxidation erfolgt in einer sauerstoffhaltigen Atmosphäre, die gegebenenfalls Zusätze, beispielsweise von HCl oder Stickstoff, enthält. Vorzugsweise erfolgt die Oxidation bei einer Temperatur im Bereich von 800 °C bis 900 °C. Danach wird auf die Isolationsschicht 110 ein Halbleitermaterial aufgebracht, das eine zweite Gateelektrode 120 bildet. Bei dem Halbleitermaterial handelt es sich beispielsweise um polykristallines Silizium. Das Halbleitermaterial ist mit einem Dotierstoff, beispielsweise Phosphor, in einer Konzentration von vorzugsweise etwa 1 x 10²¹ cm⁻³, dotiert.

Die zweite Gateelektrode 120 weist einen sich flächenförmig erstreckenden Bereich 130 und einen dazu senkrechten Vorsprung 140 auf, der in den Graben 53 eindringt. Der Bereich 130 der zweiten Gateelektrode 120 erstreckt sich im wesentlichen parallel zu der ersten Gateelektrode 40, reicht aber über diese hinaus.

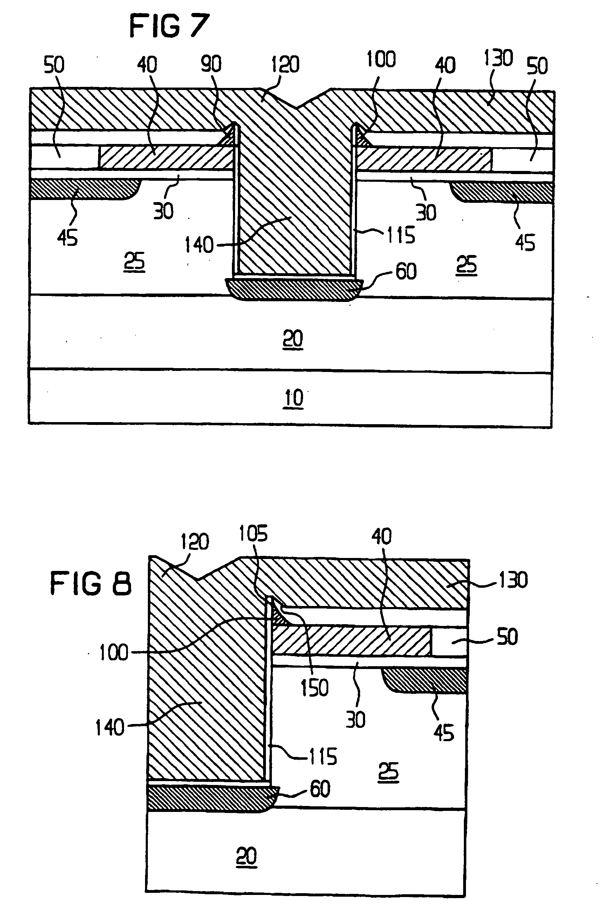

In eine Übergangszone zwischen dem Vorsprung 140 und dem flächenförmigen Bereich 130 der zweiten Gateelektrode 120 ragen die Spitzen 90 und 100 derart hinein, daß an diesen Stellen die zweite Gateelektrode 120 eine Einbuchtung 150 aufweist. Die Einbuchtung 150 ist in der Detailansicht in Figur 8 vergrößert dargestellt. Hierbei ist auch ersichtlich, daß die Spitze 100 einen Abschnitt 105 aufweist, der sich im wesentlichen parallel zu dem Vorsprung 140 der Gateelektrode 120 erstreckt, wobei der.Abschnitt 105 in der Nähe der Berührungsfläche zwischen dem Vorsprung 140 und dem flächenförmigen Bereich 130 der zweiten Gateelektrode am nächsten kommt.

Durch die Drain 45, die Source 60, den Kanal 25, das Gatedielektrikum 115 und die zweite Gateelektrode 120 wird ein vertikaler Transistor gebildet.

Die so hergestellte Speicherzelle wird mit üblichen Prozeßschritten, beispielsweise mit Aufbringen eines Zwischenoxids, Kontaktlochätzung und Erzeugung einer Metallisierung, vervollständigt.

Die fertig hergestellte Speicherzelle kann auf die nachfolgend anhand von Figur 8 dargestellte Weise programmiert werden. Hierzu werden an der Source 60 Ladungsträger erzeugt, die aufgrund einer Potentialdifferenz an der Grenze zu der ersten (floatenden) Gateelektrode 40 in die erste (floatende) Gateelektrode 40 injiziert werden. Bei geeigneten Spannungsbedingungen, bei denen die zweite (Select-Gate) Gateelektrode 120 eine Spannung aufweist, die etwas über der Einsatzspannung des durch die Drain 45, die Source 60, den Kanal 25, das Gatedielektrikum 115 und die zweite Gateelektrode 120 gebildeten vertikalen Transistors liegt, erfolgt nur ein sehr geringer Stromfluß. Dies stellt einen Unterschied zu der bekannten Programmierung mit heißen Ladungsträgern dar, bei der der Transistor in Sättigungsspannung betrieben wird. Die Spannung, die an der zweiten Gateelektrode anliegt, kann bei der erfindungsgemäßen Speicherzelle in Abhängigkeit von einer gewünschten Programmierzeit gewählt werden. Diese Spannung variiert dabei zwischen einer von außen anliegenden Betriebsspannung und der Einsatzspannung des vertikalen Transistors. Wenn die Spannung gleich der Einsatzspannung ist, dann ist die Programmierzeit hoch, es fließt aber nur ein sehr geringer Strom. Hierdurch ist die für den Schaltvorgang erforderliche Leistung sehr gering. Durch eine Erhöhung der Spannung wird die Programmierzeit verkürzt, jedoch die Leistungsaufnahme erhöht. Durch die Variabilität von Programmierzeit und Leistungsaufnahme ist die Speicherzellenanordnung für eine Vielzahl von Anwendungsgebieten geeignet.

Im folgenden ist ein Anwendungsbeispiel dargestellt:

Die Spannung an der Source 60 beträgt 0 V, an der Drain 45 12 V und an der zweiten Gateelektrode 120 1,5 V. Ein Löschen der Speicherzelle erfolgt durch ein Tunneln zwischen der Spitze 100 und der zweiten Gateelektrode 120. Aufgrund des Spitzeneffektes treten hier sehr hohe elektrische Felder auf und ein Stromfluß findet nur an der Spitze 100 statt.

Eine derartige Speicherzelle zeichnet sich durch ihren geringen Flächenverbrauch von beispielsweise 6 F² aus.

Der dargestellte Prozeß zu ihrer Herstellung ist besonders zweckmäßig, weil er selbstjustiert erfolgt und so eine definierte Geometrie der Bestandteile der Speicherzelle sicherstellt. Insbesondere wird so eine definierte Kanallänge erzielt.

Nachfolgend wird eine Aufsicht auf die Speicherzellenanordnung sowie eine Schaltung zum elektrischen Anschluß der Speicherzellenanordnung erläutert.

Bei der in Figur 9 dargestellten Speicherzellenanordnung handelt es sich um ein Zweifach-AND. Hierbei sind mehrere Speicherzellen 150 dargestellt, welche jeweils eine Zellgröße von 6 F² aufweisen. Die Breite der einzelnen Quadrate, welche die Source 60 oder die Drain 45, 145 bilden, entspricht der minimalen Strukturgröße F des Herstellungsprozesses der Speicherzelle.

Hierbei bilden die Drains 45, 145 Bitleitungen. Die Kreuzungspunkte der Bitleitungen mit Wortleitungen bilden einzelne Speicherzellen der Speicherzellenanordnung. Die zweiten Gateelektroden 120 sind durchgehend gestaltet, so daß sie jeweils eine mehrere MOS-Transistoren ansteuernde Wortleitung bilden.

Die Source 60 und zwei durch Drains 45, 145 gebildete Bitleitungen sind von Isolationsgräben 170 seitlich begrenzt. Die Isolationsgräben 170 isolieren die Bitleitungen gegeneinander. Dabei verlaufen die Isolationsgräben 170 parallel zu den Bitleitungen. Weitere Isolationsgebiete 180 dienen zur Isolation der ersten Gateelektroden 40.

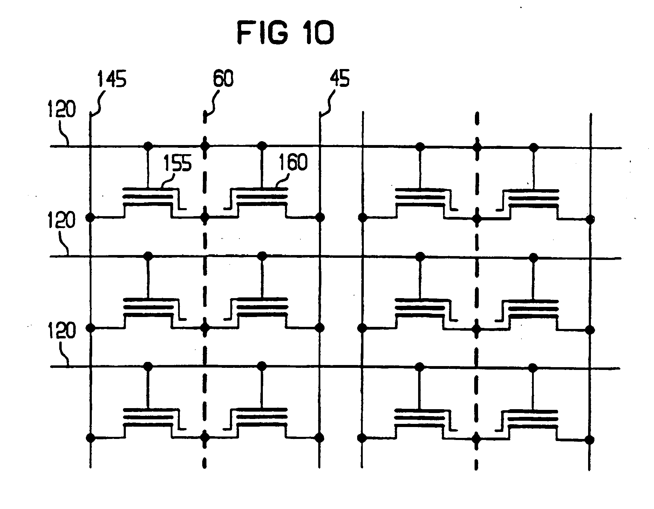

Das Schaltbild der in Figur 9 dargestellten Speicherzellenanordnung ist in Figur 10 dargestellt, wobei die zweite Drain mit der Bezugsziffer 145 gekennzeichnet ist. Jeweils zwischen einer ersten Drain 45 und einer zweiten Drain 145 befindet sich eine Source 60, so daß sich zwei parallele Reihen von Transistoren 155, 160 in Richtung der Längsausdehnung der Source 60 bilden. Senkrecht zu der Längsrichtung der Source 60 sowie der ersten Drain 45 und der zweiten Drain 145 erstrecken sich zweite Gateelektroden 120, die parallel zueinander in einem gleichbleibenden Abstand - vorzugsweise von der Strukturgröße F - angeordnet sind.

Typische Spannungen zum Programmieren, zum Schreiben und zum Lesen der Speicherzellenanordnung sind in der nachfolgenden Tabelle wiedergegeben, wobei die Drain 45 mit Drain1 und die Drain 145 mit Drain2 bezeichnet ist.

| | Drain1 | Drain2 | Gate | Source |
|---|---|---|---|---|
| Programmieren | 12 V | 0 V | 1.5 V | 0 V |
| Löschen | 0 V | 0 V | 12 V | 0 V |
| Lesen | 2.5 V | 0 V | 2.5 V | 0 V |

## Patentansprüche

1. Verfahren zur Herstellung einer Speicherzelle mit einem MOS-Transistor, bei dem
- auf einem Halbleitersubstrat (10, 20, 25) zuerst eine dielektrische Schicht für die Bildung eines Gatedielektrikums (30) aufgewachsen wird und dann eine erste elektrisch leitfähige Schicht für die Bildung einer ersten Gateelektrode (40) sowie eine weitere dielektrische Schicht (50) abgeschieden werden,
- in einem späteren Prozessschritt ein Bereich aus der ersten elektrisch leitfähigen Schicht und aus der darunter liegenden dielektrischen Schicht sowie des Halbleitersubstrats entfernt wird und in diesem Bereich eine zweite Gateelektrode (120) so erzeugt wird, dass sie wenigstens in diesem Bereich in das Halbleitersubstrat eindringt,
- in dem Halbleitersubstrat (10) verschieden dotierte Gebiete für eine Source (60), eine Drain (45) und einen Kanal (25) gebildet werden, und
- in dem Bereich ein weiteres Gatedielektrikum (115) und mindestens ein Teil der zweiten Gateelektrode (140) gebildet werden
**dadurch gekennzeichnet,**
**dass** auf der ersten elektrisch leitfähigen Schicht wenigstens eine scharfe, vorspringende Kante (90, 100) erzeugt wird, indem:
-- in dem Bereich, in dem Material aus der ersten elektrisch leitfähigen Schicht, der dielektrischen Schicht (30) und.dem Halbleitersubstrat entfernt wurde, eine Füllstruktur (70) erzeugt wird, die die erste elektrisch leitfähige Schicht überragt,
-- an Flanken der Füllstruktur (70), die die elektrisch leitfähige Schicht überragen, die Kante (90, 100) erzeugt wird,
-- die Füllstruktur (70) selektiv entfernt wird.

2. Verfahren nach Anspruch 1,
**dadurch gekennzeichnet,**
**dass** die erste elektrisch leitfähige Schicht, die dielektrische Schicht, die weitere dielektrische Schicht sowie das Halbleitersubstrat bereichsweise durch einen oder mehrere Ätzvorgänge entfernt werden.

3. Verfahren nach Anspruch 2,
**dadurch gekennzeichnet,**
**dass** der Ätzvorgang in einem Bereich (25) des Halbleitersubstrats (10) erfolgt, der eine andere Leitfähigkeit der Dotierung enthält als andere Bereiche des Halbleitersubstrats.

4. Verfahren nach einem der Ansprüche 1 bis 3,
- bei dem zur Bildung der Kante (90, 100) eine Halbleiterschicht (80) abgeschieden wird, die die Flanken der Füllstruktur (70) überdeckt und die isotrop oxidiert wird, und
- bei dem das aus der Halbleiterschicht (80) gewachsene Oxid selektiv entfernt wird, so dass nicht oxidierte Reste der Halbleiterschicht (80) bestehen bleiben, die die Kante (90, 100) darstellen.

## Claims

1. Method for fabricating a memory cell having a MOS transistor, in which
- firstly a dielectric layer for forming a gate dielectric (30) is grown on a semiconductor substrate (10, 20, 25) and a first electrically conductive layer for forming a first gate electrode (40) and also a further dielectric layer (50) are deposited,
- in a later process step, a region from the first electrically conductive layer and from the underlying dielectric layer and also of the semiconductor substrate is removed and a second gate electrode (120) is produced in said region in such a way that it penetrates into the semiconductor substrate at least in said region,
- differently doped regions for a source (60), a drain (45) and a channel (25) are formed in the semiconductor substrate (10), and
- a further gate dielectric (115) and at least one part of the second gate electrode (140) are formed in the region,
**characterized**
**in that** at least one sharp, projecting edge (90, 100) is produced on the first electrically conductive layer by a procedure in which:
- in the region in which material has been removed from the first electrically conductive layer, the dielectric layer (30) and the semiconductor substrate, a filling structure (70) is produced which projects above the first electrically conductive layer,
- the edge (90, 100) is produced on sidewalls of the filling structure (70) which project above the electrically conductive layer,
- the filling structure (70) is selectively removed.

2. Method according to Claim 1,
**characterized**
**in that** the first electrically conductive layer, the dielectric layer, the further dielectric layer and also the semiconductor substrate are removed in regions by means of one or more etching operations.

3. Method according to Claim 2,
**characterized**
**in that** the etching operation is performed in a region (25) of the semiconductor substrate (10) which contains a different conductivity of the doping than other regions of the semiconductor substrate.

4. Method according to one of Claims 1 to 3,
- in which, in order to form the edge (90, 100), a semiconductor layer (80) is deposited which covers the side walls of the filling structure (70) and is oxidized isotropically, and
- in which the oxide grown from the semiconductor layer (80) is removed selectively, so that non-oxidized residues of the semiconductor layer (80) remain, which constitute the edge (90, 100).

## Revendications

1. Procédé de production d'une cellule de mémoire ayant un transistor MOS, dans lequel
- on fait croître sur un substrat (10, 20, 25) semi-conducteur d'abord une couche diélectrique pour la formation d'un diélectrique (30) de grille et ensuite on dépose une première couche (36) conductrice de l'électricité pour la formation d'une première électrode de grille ainsi qu'une couche (50) diélectrique supplémentaire ;
- dans un stade ultérieur du procédé, on élimine une partie de la première couche conductrice de l'électricité et de la couche diélectrique sous-jacente ainsi que du substrat semi-conducteur et on produit dans cette partie une deuxième électrode (120) de grille qui pénètre au moins dans cette partie dans le substrat semi-conducteur ;
- on forme dans le substrat (10) semi-conducteur diverses zones dopées pour une source (60), un drain (45) et un canal (25) ; et
- on forme dans la partie un diélectrique (115) de grille supplémentaire et au moins une partie de la deuxième électrode (140) de grille,
**caractérisé**
**en ce que** l'on produit sur la première couche conductrice de l'électricité au moins une arête (90, 100) vive en saillie en :
-- produisant, dans la partie dans laquelle du matériau a été éliminé de la première couche conductrice de l'électricité, de la couche (30) diélectrique et du substrat semi-conducteur, une structure (70) de remplissage qui dépasse de la première couche conductrice de l'électricité ;
-- en produisant l'arête (90, 100) sur des flancs de la structure (70) de remplissage, qui dépassent de la couche conductrice de l'électricité,
-- en éliminant sélectivement la structure (70) de remplissage.

2. Procédé suivant la revendication 1,
**caractérisé**
**en ce que** l'on élimine la première couche conductrice de l'électricité, la couche diélectrique, la couche diélectrique supplémentaire ainsi que le substrat semi-conducteur par endroit par une opération d'attaque ou par plusieurs opérations d'attaque.

3. Procédé suivant la revendication 2,
**caractérisé en ce que** l'on effectue l'opération d'attaque dans une partie (25) du substrat (10) semi-conducteur, qui a une autre conductivité du dopage que d' autres parties du substrat semi-conducteur.

4. Procédé suivant l'une des revendications 1 à 3,
- dans lequel, pour former l'arête (90, 100), on dépose une couche (80) semi-conductrice qui recouvre les flancs de la structure (70) de remplissage et que l'on oxyde de façon isotrope ; et
- dans lequel on élimine sélectivement l'oxyde qui a crû à partir de la couche (80) semi-conductrice de manière à laisser subsister des restes non oxydés de la couche (80) semi-conductrice qui constitue l'arête (90, 100).
